**Europäisches Patentamt**

**European Patent Office**

**Office européen des brevets**

(19)

(11) **EP 1 408 513 A1**

(12) **EUROPEAN PATENT APPLICATION**

(43) Date of publication:
**14.04.2004 Bulletin 2004/16**

(51) Int Cl.⁷: **G11C 29/00**

(21) Application number: **02292946.7**

(22) Date of filing: **28.11.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI**<br><br>(30) Priority: **07.10.2002 EP 02022312**<br><br>(71) Applicant: **Infineon Technologies AG**<br>**81669 München (DE)**<br><br>(72) Inventors:<br>• **Tellier, Yann**<br>**06250 Mougins (FR)** | • **Jallamion-Grive, Yannis**<br>**06250 Mougins (FR)**<br>• **Coste, Jean-Patrice**<br>**06600 Antibes (FR)**<br>• **Vial, Jean-Christophe**<br>**06600 Antibes (FR)**<br><br>(74) Representative: **Charles, Glyndwr et al**<br>**Reinhard-Skuhra-Weise & Partner,**<br>**Patentanwälte,**<br>**Friedrichstrasse 31**<br>**80801 München (DE)** |

(54) **Carry decoder for a memory**

(57)     Carry decoder for a memory having input/output units (A,B,C) connected via bitlines (BL) to memory cells and at least one redundant input/output unit (D) connected via bitlines (BL) to redundant memory cells, wherein each input/output unit has a multiplexer (7) comprising a first data input (8) connected to the input/output unit, a second data input (10) connected to an adjacent input/output unit and a data output (12) connected to a data pad (15) of the memory (1). A carry decoder stage ($17_i$) comprises decoding means (19) which generates a switch control signal bit to switch the corresponding multiplexer (7) from the first data input (8) to the second data input (10) when the input/output unit (A,B,C) is faulty, and a logic circuit (22) for logically combining the generated switch control bit with an output bit of the logic circuit (22) of the previous carry decoder stage ($17_{i+1}$) to generate an output bit for the next carry decoder stage ($17_{i+1}$).

FIG 8

EP 1 408 513 A1

## Description

Semiconductor memories are binary data memories in which a plurality of memory cells are provided. The memory cells are addressable by means of wordlines and bitlines. The main memory comprises a matrix of many memory cells connected to address decoding means and sense amplifiers. Addressing a memory cell, i.e. the selection of a memory cell, is performed by activating wordlines which are connected to address decoding means. The data stored in the addressed memory cells are read out by input/output units having sense amplifiers for amplifying the read-out data signal. The input/output units are connected to a data bus by means of which data can be read out from the memory or written into the memory.

When a random access memory is produced, it can happen that some of the memory cells within the matrix are faulty. Accordingly, the produced memory chip is tested, and it is decided whether it can be repaired. For this purpose, there is normally provided an on-chip circuitry to provide testing of the memory chip. The built-in self-test (BIST) is essentially the implementation of logic built into the memory chip to do testing without the use of a tester for data pattern generation on comparison purposes.

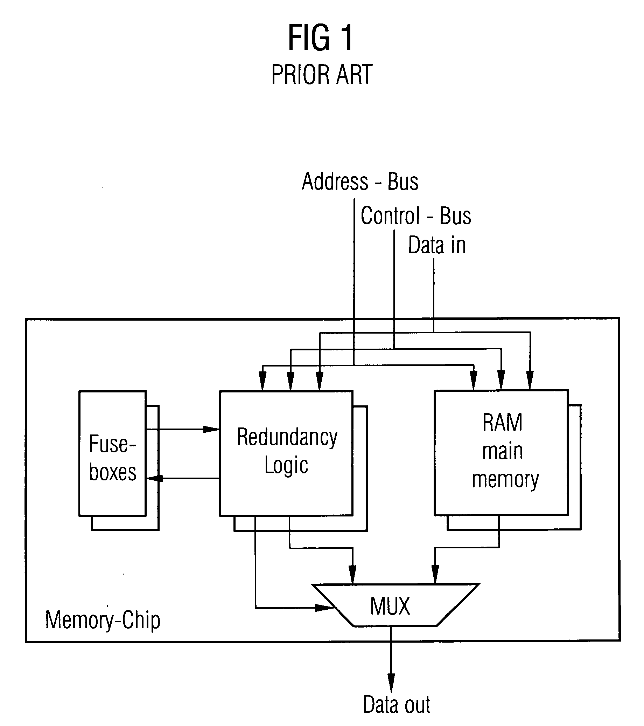

Fig. 1 shows the architecture of a memory chip according to the state of the art. The memory chip comprises a main memory with a plurality of memory cells and a redundancy logic having a built-in self-test device. The memory chip is connected to an address bus, a control bus and a data bus. In a test mode, the addresses of the faulty memory cells are detected. The redundancy logic replaces the faulty memory cells within the main memory with memory cells in the form of redundant registers within the redundancy logic. For this purpose the redundancy logic programs fuses within a fusebox. The address applied to the address bus is compared with the addresses of the detected faulty memory cells, and when there is a match, the redundancy logic maps the faulty address to an address of a register cell within the redundancy logic to replace the faulty memory cell. When reading data from the memory chip, the redundancy logic controls a multiplexer connected to the data bus. When accessing data with an address of a faulty memory cell, the data is read from the register replacing the memory cell within the redundancy logic.

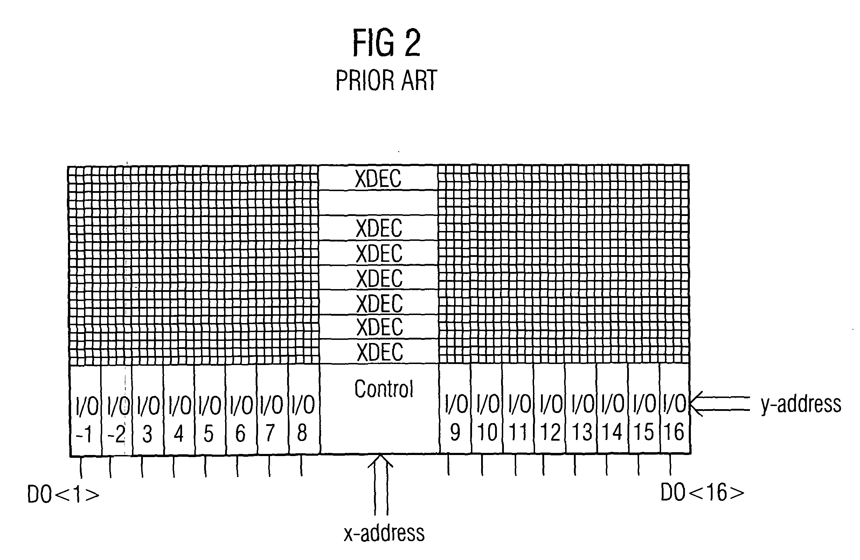

Fig. 2 shows the architecture of a main memory within the memory chip according to the state of the art. In this example, the main memory is a 8k x 16 wide memory having 16 input/output units and wordline address decoders (XDEC) for decoding the wordline address or X-address of the memory cells. The input/output units are connected to the memory cell matrix by means of vertical bitlines. The input/output units receive the bitline address or Y-address of the selected memory cell.

The main memory shown in Fig. 2 according to the state of the art is partitioned in two memory halfes wherein the X-address decoders are placed in the center. With this architecture, the length of the wordlines is comparatively short so that the parasitic capacitance of the wordlines can be minimized. Each input/output unit is connected to the 16 bitlines reading data from the addressed memory cell and for writing data into an addressed memory cell.

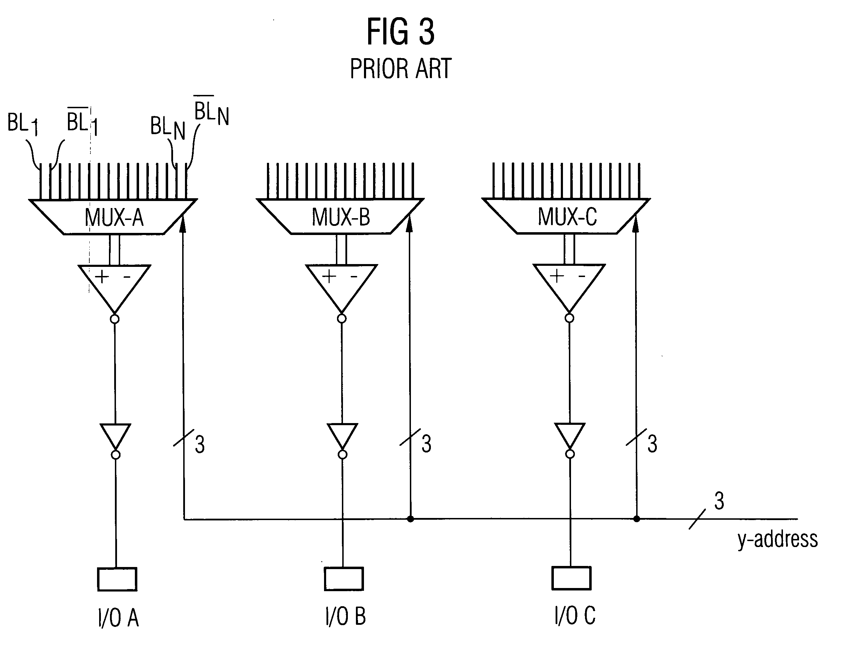

Fig. 3 shows the architecture of an input/output unit according to the state of the art. For reading out data, the input/output unit comprises multiplexer which are connected to the bitlines of the memory cell matrix. In the shown example, each memory cell is connected to a multiplexer via a couple or pair of bitlines BL, $\overline{BL}$ to provide a differential signal to the input of the multiplexer. In the shown example, each multiplexer has N signal inputs. On the output side, each multiplexer is connected to a differential amplifier and an inverter for amplifying the read-out data signal and to supply the data to a data bus. The multiplexer are controlled by the applied Y-address. Each input output unit (IO) comprises a column decoder and a read/write amplifier.

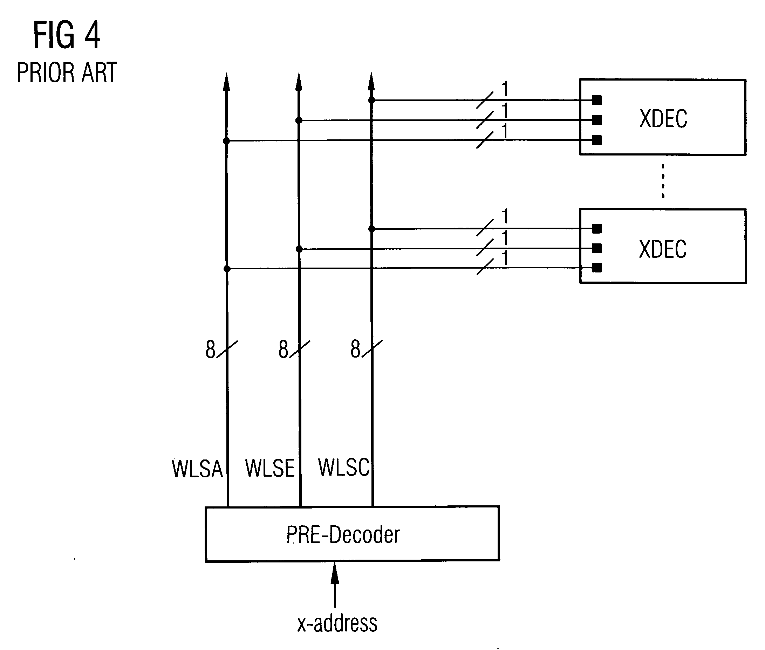

Fig. 4 shows the architecture of an X-address decoder according to the state of the art used in a conventional main memory as shown in Fig. 2. A predecoder is connected via three 8 bit wide busses to X-address decoders which decode the X-address of the selected memory cell within the memory cell matrix.

In a conventional memory, there are provided either redundant registers, redundant bitlines and/or wordlines to repair a memory chip in case that faulty memory cells are detected when testing the memory chip.

If the conventional memory chip comprises redundant registers, the number of faulty addresses is limited by the number of redundant registers provided within the redundancy logic. If there are, for instance, 10 redundant registers, it is only possible to repair 10 faulty addresses. When an address is "faulty", the address is stored in a redundant register. Since the number of faulty addresses detected by the main memory, it is not known before testing a considerable number of registers have to be provided within the redundancy logic to guarantee the repair of the chip even when a lot of memory cells are detected to be faulty.

In case that the memory chip comprises redundant bitlines and/or wordlines, the repair method is much more complex, because all errors have to be known in advance before the error pattern can be diagnosed and an optimal repair solution can be calculated. Storing detected memories with a conventional method implies a very large array.

Such an array needs a lot of space on the memory chip, thus increasing costs when producing the memory chip.

In European patent application EP 02022312.9 filed on October 7, 2002 a method for storing detected errors in a separate diagnose array having a minimum storage and a memory chip having a diagnose array with a minimum storage size for storing detected errors of a main memory within the memory chip are described.

This object is solved by a method having the features of main claim 1 and by a memory chip having the features of main claim 6.

As can be seen from Fig. 5, the memory chip as described in EP 02022312.9 comprises a memory with a built-in redundancy. The memory comprises a plurality of memory cells which are addressable by means of wordlines and bitlines. The memory comprises redundant wordlines and redundant bitlines which are provided for repairing faulty memory cells. The memory is connected to a control block, a BIST-unit and a repair unit. The repair unit is connected to programmable fuses which are provided for replacing wordlines by redundant wordlines and input/output units by redundant input/output units within the memory.

The built-in self-test unit performs a test of the memory within the chip and checks whether there are any memory cells which are defect. The diagnose unit consists of a control unit and a diagnose array. The diagnose array is provided for storing logically detected errors within the main memory found by the built-in self-test device in a test mode. The diagnose array stores in a logical manner the errors found in the memory. The control unit 5a controls the storing of detected errors into the diagnose array 5b and analyzes the stored errors to select wordlines and input/output units within the memory to be replaced by redundant wordlines and redundant input/output units. Depending on the analyzing result, the repair unit programs fuses in a fusebox connected to the main memory. A basis of the data content of the storage table within the diagnose array, the repair unit performs a pre-fuse of the fuses to replace wordlines in the input/output unit of faulty memory cells by redundant wordlines and redundant input/output units. In the next step, the provisionally repaired memory is again tested, and if no further errors are detected, the fuses in the fusebox are blown.

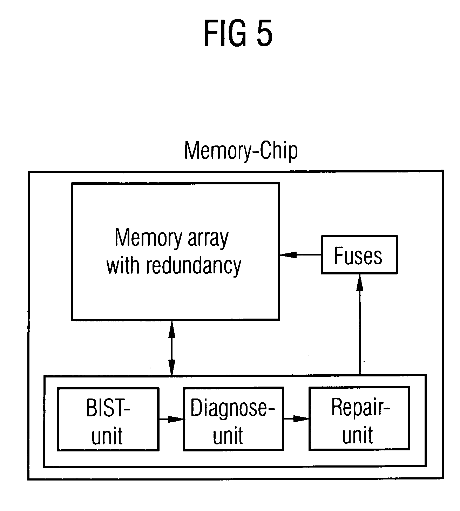

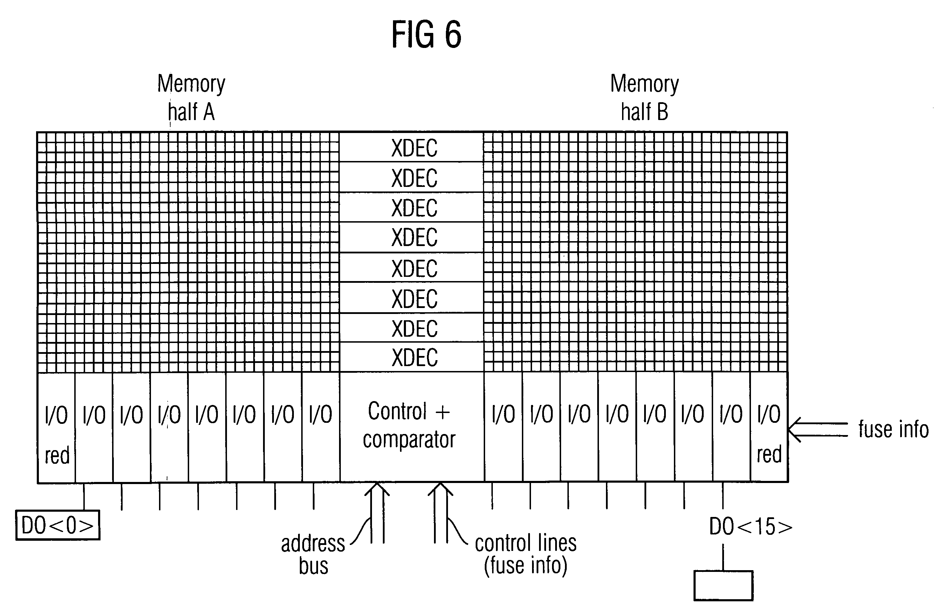

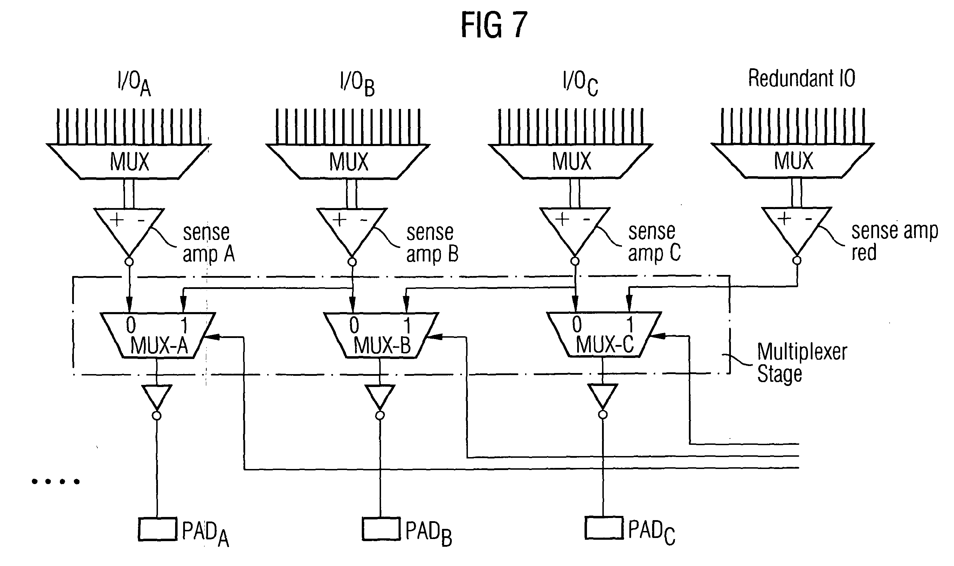

Fig. 6 shows a memory array within a memory chip as shown in Fig. 5. The memory is partitioned in two memory halfes 2a, 2b, each having a matrix of memory cells. The memory cells are connected to x-address-decoders (XDEC) and to input/output units I/O. The input/output units are connected to data input/output pads of the memory chip. Each input/output unit I/O is for example connected to 16 bitlines of the memory cell array.

As can be seen from Fig. 6, the memory further comprises redundant X-address decoders XDEC and redundant input/output units I/O red. Further, a control and comparator unit is provided connected to the address bus and to the fusebox via control lines.

Fig. 7 shows the architecture of the input/output units I/O in the memory chip as described in EP 02022312.9. As can be seen from Fig. 7, there is provided a redundant input/output unit I/O redundant which may be activated by the programmed fuses. The fusebox is connected via control lines to multiplexer MUX A, B, C within a multiplex stage. The fusebox comprises the information data on the input/output unit I/O to be replaced by the redundant input/output unit I/O redundant. A control signal is supplied to the multiplexer stage to block the input/output I/O which is connected to a faulty memory cell within the memory and which is decided to be replaced from the corresponding pad. Further, the redundant input/output unit I/O red is connected to pad C as a substitute. The redundant input/output unit is set by the fuses. Providing the additional multiplexer stage has almost no impact on the signal delay.

A preferred embodiment of the method according to the present invention and of the memory chip according to the present invention is explained with reference to the enclosed figures:

Fig. 1 shows a memory chip with a redundancy logic according to the state of the art;

Fig. 2 shows the main memory within a memory chip according to the state of the art;

Fig. 3 shows an input/output unit according to the state of the art;

Fig. 4 shows an X-address decoder according to the state of the art;

Fig. 5 shows the architecture of a memory chip as described in EP 02022312;

Fig. 6 shows a main memory within a memory chip with a redundancy as described in EP 02022312;

Fig. 7 shows an input/output unit within a memory chip as described in EP 02022312;

Fig. 8 shows a preferred embodiment also a carry decoder for a memory according to the present invention;

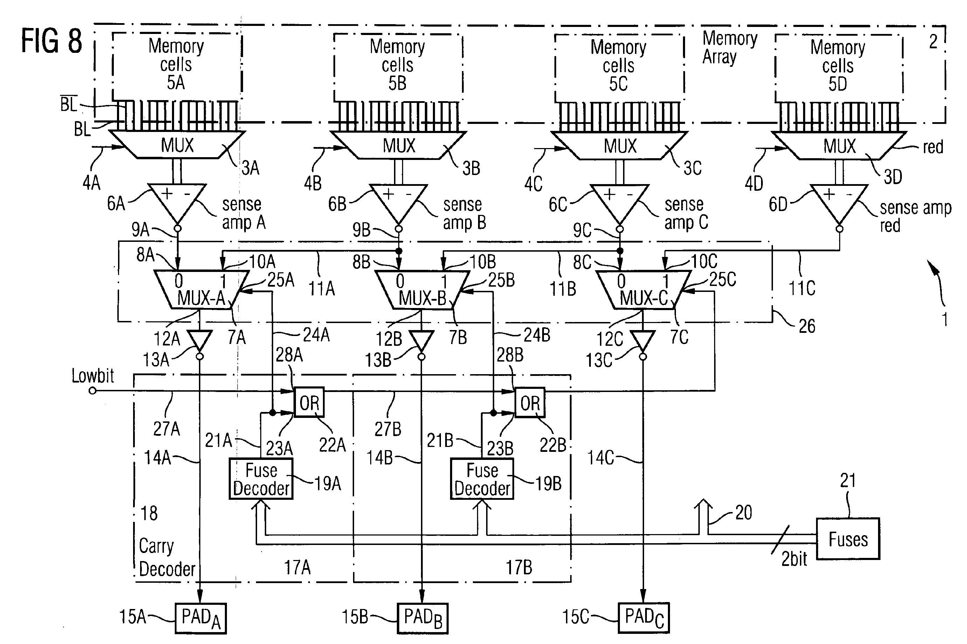

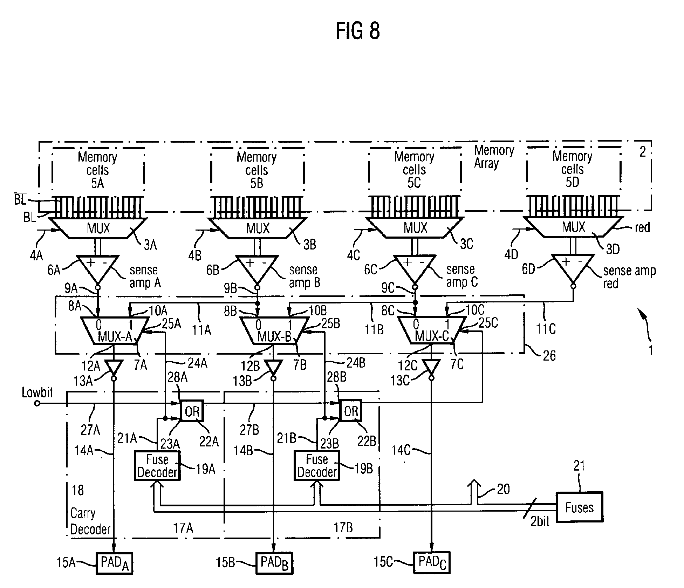

As can be seen from Fig. 8 a memory 1 according to flie present invention comprises a memory array 2 with a plurality of memory cells. Memory Cells are connected to x-address-decoders and to input/output units. The memory cells are addressable by means of wordlines (WL)and bitlines (BL). In the given example of Fig. 8 each memory cell is connected via a bitline BL and an inverted bitline BL to a multiplexer or column decoder to provide a differential output signal. In the embodiment shown in Fig. 8 eight columns of memory cells of the memory array 2 are connected to a muliplexer $3_i$ having a control input 4. The muliplexer 3 receives a control signal from a column decoder to select one of eight columns of the corresponding memory-subarray 5 of the memory 2.

Fig. 8 shows a simple structure of a memory having only four different memory subarrays 5. The memory subarray 5d shown in Fig. 8 comprises redundant memory cells to substitute memory cells of input/output units which have failed. The memory 1 is for example a SRAM-memory with several megabit of storage capacity. The bitlines connected to the multiplexer 3-i are amplified by corresponding sense amplifiers connected to the output of the multiplexer via differential signal lines. Fig. 8 shows only the structure to read signals from the memory array 2. The memory chip 1 is also provided with write amplifiers for writing bits into the memory cells. Due to the chip area needed for a read and write amplifier it is not possible to provide an amplifier for each single bitline of the memory array 2. To save area multiplexers 3a to 3d are provided muliplexing typically eight or sixteen columns to one amplifier 6.

As can be seen from Fig. 8 for each non redundant submemory array 5 a corresponding additional multiplexer $7_i$ is provided having two data inputs and one data output. The first data input 8 of each multiplexer 7 is connected via a line 9 to the output of the corresponding sense amplifier 6. The second data input 10 of each multiplexer 7 is connected via a signal line 11 to the output of the sense amplifier of the adjacent input/output unit. For example the data input 10a of the first input/output unit A is connected via line 11a to the output of the sense amplifier 6b belonging to the adjacent input/output unit B. Each multiplexer 7 comprises an output 12 connected via an inverter 13 and a line 14 to a data pad 15 of the memory chip 1. The data pads 15 are connected to an external data bus (not shown).

As can be seen from Fig. 8 for each regular input/output unit A to C with the exemption of the last regular input/output unit C a carry decoder stage 17 of the carry decoder 18 is provided. Each carry decoder stage 17 comprises decoding means 19 connected via bitlines 20 to a fusebox 21. In the given example each fuse decoder 19 is connected via two bitlines to the fusebox 21. The fuse decoder 19 of each carry decoder stage receives a digital signal from the fusebox 21 indicating the input/output unit A, B, C which has failed. The fuse decoder 19 generates a switch control bit for the corresponding input/output unit which is faulty. For example when the input/output unit B has failed the fuse decoder 19b will generate the switch control signal bit and apply this generated bit via a line 21 to a logic circuit 22 connected to the fuse decoder 19. In the embodiment shown in Fig. 8 the logic circuit 22 is an OR-gate. If for instance the input/output unit B is faulty as indicated by the fuses within the fusebox 21, the fuse decoder 19b generates a logically high bit and applies this bit to a first input 23b of the corresponding OR-gate 22b within the carry decoder stage 17b. The logic high bit of the fuse decoder 19 is first applied via a control line 24b to a control input 25b of the corresponding multiplexer 7b of the input/output unit B. This control bit causes the multiplexer 7b to switch from data input 8b to data input 10b. As a consequence the failed input/output unit B is replaced by its neighbouring input/output unit C. Since the fuse decoder 19a of the previous carry decoder stage still applies a logical low control bit via line 24a to the control input 25a of multiplexer 7a the first data input 8a of multiplexer 7a is kept switched to the data pad 15a of the memory chip 1. In this manner the second data input 10a of multiplexer 7a is blocked and the input/output unit B connected to the memory subarray 5b is deactivated. The memory location is completely shifted from the memory subarray 5b to the memory subarray 5c. From an external point of view the output data pad can not be changed when replacing a subarray 5. Accordingly when shifting for example the memory subarray 5b to memory subarray 5c the data output of multiplexer 3c is switched to the correct data output pad 15b. Accordingly of data bus redirection is performed by the multiplexer stage 26 which comprises multiplexers 7a, 7b, 7c. When substituting a memory subarray by another memory subarray for instance memory subarray 5b by its neighbouring memory subarray 5c this substitution process is continued until the redundant memory subarray 5d is reached. For the given example Fig. 8 memory subarray 5c which substitutes memory subarray 5b is itself substituted by the redundant memory subarray 5d. This redundancy information is spread by means of the carry decoder 18 according to the present invention.

If for example the input/output unit A is indicated as the faulty input/output unit the fuse decoder 19a generates a logical high control bit and applies it to the input 23a of the OR-gate 22a. The OR-gate combines this high control bit with a pre-set logical low bit applied to the OR-gate via line 27 for a second input 28a of the OR-gate 22a. Consequently the OR-gate 22a outputs a logical high bit via line 27b to the input 28b of the next OR-gate 22b. The carry decoder stages $17_i$ are connected in a cascade structure so that when a fuse decoder $19_i$ of an input/output unit generates the logical high bit this information is spread to all following carry decoder stages 17i+j. The carry decoder 18 thus switches all following multiplexer 7i+j to the second data input 10, respectively.

The failed input/output unit is decoded and the redundant information is spread via a carry system up to the redundant input/output unit D. Spreading the redundancy info instead of implementing more fuses within the fusebox 21 safes area inside the memory chip 1. Further area outside the chip is saved since less fuses are required. The OR-gates 22 of the carry decoder 8 causes a kind of domino effect, so that when an input/output unit i is replaced by its neighbouring input/output unit i+l all further input/output units i+l+j are also switched to its corresponding neighbouring input/output units until the redundant input/output unit R is reached. The carry decoder 18 according to the present mention is designed to have a minimum logical complexity to achieve the shifting operation. Each carry decoder stage 17 of the carry decoder 18 has a fuse decoder 19 and an OR-gate 22 having a very low technical complexity. As a consequence the area on the chip provided to implement the carry decoder 18 according to the present invention is very small. The carry decoder 18 according to the present invention is very efficient in terms of area and it is easy to implement.

**Claims**

1. Carry decoder for a memory having:

   (a) input/output units (A, B, C) connected via bitlines (BL) to memory cells;

   (b) at least one redundant input/output unit (D) connected via bitlines (BL) to redundant memory cells;

   (c) wherein each input/output unit has:

      (c1) a multiplexer (7) comprising
      a first data input (8) connected to the input/output unit,
      a second data input (10) connected to an adjacent input/output unit and
      a data output (12) connected to a data pad (15) of the memory (1); and

      (c2) a carry decoder stage ($17_i$) comprising:

         decoding means (19) which generates a switch control signal bit to switch the corresponding multiplexer (7) from the first data input (8) to the second data input (10) when the input/output unit (A, B, C) is faulty and
         a logic circuit (22) for logically combining the generated switch control bit with an output bit of the logic circuit (22) of the previous carry decoder stage ($17_{i-1}$) to generate an output bit for the next carry decoder stage ($17_{i+1}$).

2. Carry decoder according to claim 1, wherein the logic circuit (22) is an OR-gate.

3. Carry decoder according to claim 1, wherein the decoding means (19) are connected via lines (20) to a fusebox (21) indicating a faulty input/output unit (A, B, C).

4. Carry decoder according to claim 1, wherein the carry decoder (18) has several carry decoder stages (17) connected in a cascade structure.

5. Carry decoder according to claim 1 wherein the input/output unit (A, B, C) comprises a column decoder (3) connected to the memory cells (5a) via bitlines (BL) and a read/write amplifier (6).

6. Carry decoder according to claim 2, wherein the OR-gate of the first carry decoders (17a) combines the generated switch control bit with a pre-set logical low bit.

# FIG 1
## PRIOR ART

Address - Bus

Control - Bus

Data in

Fuse-boxes

Redundancy Logic

RAM main memory

MUX

Memory-Chip

Data out

## FIG 2
### PRIOR ART

EP 1 408 513 A1

# FIG 3
## PRIOR ART

EP 1 408 513 A1

## FIG 4
### PRIOR ART

# FIG 5

Memory-Chip

# FIG 6

EP 1 408 513 A1

Memory
half A

Memory
half B

| | XDEC | |
| | XDEC | |
| | XDEC | |
| | XDEC | |
| | XDEC | |
| | XDEC | |
| | XDEC | |
| | XDEC | |

| I/O red | I/O | I/O | I/O | I/O | I/O | I/O | I/O | Control + comparator | I/O | I/O | I/O | I/O | I/O | I/O | I/O | I/O red |

← fuse info

DO<0>

address bus

control lines (fuse info)

DO<15>

FIG 7

Redundant IO

MUX

sense amp
red

I/O$_C$

MUX

sense
amp C

Multiplexer
Stage

0 1
MUX-C

PAD$_C$

I/O$_B$

MUX

sense
amp B

0 1
MUX-B

PAD$_B$

I/O$_A$

MUX

sense
amp A

0 1
MUX-A

PAD$_A$

# FIG 8

FIG 8

**European Patent Office**

**EUROPEAN SEARCH REPORT**

Application Number

EP 02 29 2946

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 301 153 A (JOHNSON LARRY D) 5 April 1994 (1994-04-05) * column 3, line 33 - column 8, line 16; figures 2-4 * --- | 1-6 | G11C29/00 |
| A | US 6 249 465 B1 (FLEISCHMAN JAY ET AL) 19 June 2001 (2001-06-19) * column 3, line 16 - column 5, line 59; figures 3,4 * ----- | 1,3 | |

TECHNICAL FIELDS SEARCHED (Int.Cl.7)

G11C

The present search report has been drawn up for all claims

| Place of search | Date of completion of the search | Examiner |
|---|---|---|
| MUNICH | 12 February 2003 | Harms, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 29 2946

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2003

| Patent document cited in search report | | Publication date | Patent family member(s) | Publication date |
|---|---|---|---|---|
| US 5301153 | A | 05-04-1994 | NONE | |
| US 6249465 | B1 | 19-06-2001 | JP 2001273789 A | 05-10-2001 |

EPO FORM P0459

For more details about this annex : see Official Journal of the European Patent Office, No. 12/82